Europäisches Patentamt

European Patent Office

Office européen des brevets

(11) Veröffentlichungsnummer: **0 482 392 A2**

# EUROPÄISCHE PATENTANMELDUNG

(21) Anmeldenummer: **91116818.5**

(22) Anmeldetag: **02.10.91**

(51) Int. Cl.5: **H04L 25/08**

(30) Priorität: **26.10.90 DE 4034043**

(43) Veröffentlichungstag der Anmeldung:
**29.04.92 Patentblatt 92/18**

(84) Benannte Vertragsstaaten:
**AT BE CH DE DK ES FR GB IT LI NL SE**

(71) Anmelder: **Standard Elektrik Lorenz
Aktiengesellschaft
Lorenzstrasse 10
W-7000 Stuttgart 40(DE)**

(72) Erfinder: **Banniza, Thomas
Max-Eyth-Strasse 14
W-7254 Hemmingen(DE)**

(74) Vertreter: **Pechhold, Eberhard, Dipl.-Phys. et
al
Standard Elektrik Lorenz AG Patent- und
Lizenzwesen Postfach 30 09 29
W-7000 Stuttgart 30(DE)**

(54) **Schaltungsanordnung zur Bereitstellung eines Ausgangsstromes für einen Datentreiber.**

(57) Es wird eine Schaltungsanordnung zur Bereitstellung eines vorgegebenen Ausgangsstromes für einen auf eine Übertragungsleitung (L) arbeitenden Datentreiber (DT) angegeben. Der Ausgangsstrom fließt hier über mehrere parallelgeschaltete Teilstrompfade, von denen jeweils so viele von einer Steuerschaltung (ST) durchgeschaltet werden, daß sich als Gesamtstrom der gewünschte Ausgangsstrom ergibt. Die Steuerschaltung wird ihrerseits von einem Komparator (K) angesteuert, der die Ausgangsspannung des Datentreibers oder eines gleichartigen Referenzdatentreibers (RT) mit einer Referenzspannung ($U_R$) vergleicht und die Steuerschaltung zum Zuschalten oder Abschalten von Teilstrompfaden veranlaßt, wenn die Ausgangsspannung des Datentreibers von der Referenzspannung abweicht.

Fig 1

EP 0 482 392 A2

Die Erfindung betrifft eine Schaltungsanordnung gemäß dem Oberbegriff des Patentanspruchs 1.

Um Breitbandsignale unverfälscht über eine Leitung zu übertragen ist es erforderlich, die Ausgangsimpedanz des Senders und die Eingangsimpedanz des Empfängers an den Wellenwiderstand der Übertragungsleitung genau anzupassen. Dies ist vor allem dann schwierig, wenn als Sender oder Empfänger integrierte Schaltungen verwendet werden, deren Impedanzen während der Produktion nicht mit vertretbarem Aufwand auf wenige Prozent genau auf einen vorgegebenen Wert eingestellt werden können.

Um dennoch einen genauen Impedanzwert zu erhalten, kann eine Schaltung mit sehr hohem Ausgangs- oder Eingangswiderstand realisiert und diesem extern ein Widerstand zugeschaltet werden. Der externe Widerstand läßt sich vergleichsweise leicht so einstellen, daß der Gesamtwiderstand der erforderlichen Impedanz entspricht.

Die Hochohmigkeit einer solchen Schaltung bedingt, speziell bei der Anpassung von Ausgängen, eine hohe Abhängigkeit des Ausgangspegels sowie aller Pegel auf der getriebenen Leitung vom Ausgangsstrom. Dieser sollte deshalb möglichst genau eingestellt und konstant gehalten werden.

In der Regel ändern sich die Ausgangs-Nennströme von integrierten Schaltungen aber aufgrund von Prozeß-Schwankungen und aufgrund von Temperatur- und Versorgungsspannungsänderungen in Größenordnungen, die in Bipolar-Systemen ± 20 %, in CMOS-Systemen über ± 50 % erreichen können. Dies führt zu nicht akzeptablen Schwankungen der Signalpegel auf der getriebenen Leitung.

Es wurde deshalb auch bereits versucht, die Ausgangswiderstände der Ausgangsschaltungen konstant zu regeln. Eine derartige Ausgangsschaltung ist z.B. aus einem Aufsatz von Knight und Krymm in IEEE Journal of solid-state circuits, Vol. 23, No. 2, April 1988 bekannt. Diese Schaltung benötigt aber zur Regelung analoge Komponenten wie z.B. Linear-Verstärker (Fig. 9), die sie für Breitbandsignale mit mehr als 50 MBit/s unbrauchbar machen. Außerdem werden hier als Stromquellen niederohmige Schalter benützt, denen integrierte, einstellbare Serienwiderstände zugeschaltet werden.

Es ist Aufgabe der Erfindung, eine Schaltungsanordnung anzugeben, die eine Ausgangsstromregelung ohne Analogschaltungen ermöglicht und die für Breitbandsignale bis 150 MBit/s geeignet ist.

Eine Schaltungsanordnung die diese Aufgabe erfüllt, wird durch die Merkmale des Patentanspruchs 1 beschrieben. Die Parallelschaltung verschiedener Strompfade, die gleiche oder auch unterschiedlich gestaffelte parallele Ausgangswiderstände bilden, erlauben, den Gesamt-Ausgangswiderstand allein mittels Schaltern, digital einzustellen.

Weiterbildungen der Schaltungsanordnung nach der Erfindung sind in den Unteransprüchen angegeben:

So betreffen die Ansprüche 2 und 3 die Bemessung der parallelen Ausgangswiderstände. Anspruch 4 sieht die Ansteuerung von Stellgliedern mehrerer Datentreiber durch eine einzige Steuerschaltung vor. Dabei kann gemäß einer im Anspruch 5 beschriebenen Ausgestaltung der Schaltungsanordnung nach der Erfindung diese einzige Steuerschaltung einem Referenz-Datentreiber zugeordnet sein, der nicht zur Datenübertragung genutzt wird sondern, anstatt auf eine Übertragungsleitung, auf einen vorgegebenen Referenzwiderstand arbeitet.

Gegenstand des Anspruchs 6 ist eine Maßnahme zur Energieeinsparung. Sie verhindert auch eine Erwärmung des Referenzwiderstandes und eine eventuell mit dieser Erwärmung verbundene Änderung des Widerstandswertes.

Die Ansprüche 7 und 8, schließlich, betreffen Ausgestaltungen der Steuerschaltung, die die Stellglieder eines oder mehrerer Datentreiber ansteuert.

Anhand von Figuren sollen nun Ausführungsbeispiele der Schaltungsanordnung nach der Erfindung eingehend beschrieben und ihre Funktion erklärt werden.

Fig. 1    zeigt ein Blockschaltbild eines Mehrfachdatentreibers mit Referenztreiber.

Fig. 2    zeigt den Aufbau eines Datentreibers.

Fig. 3    zeigt den Aufbau einer Steuerschaltung.

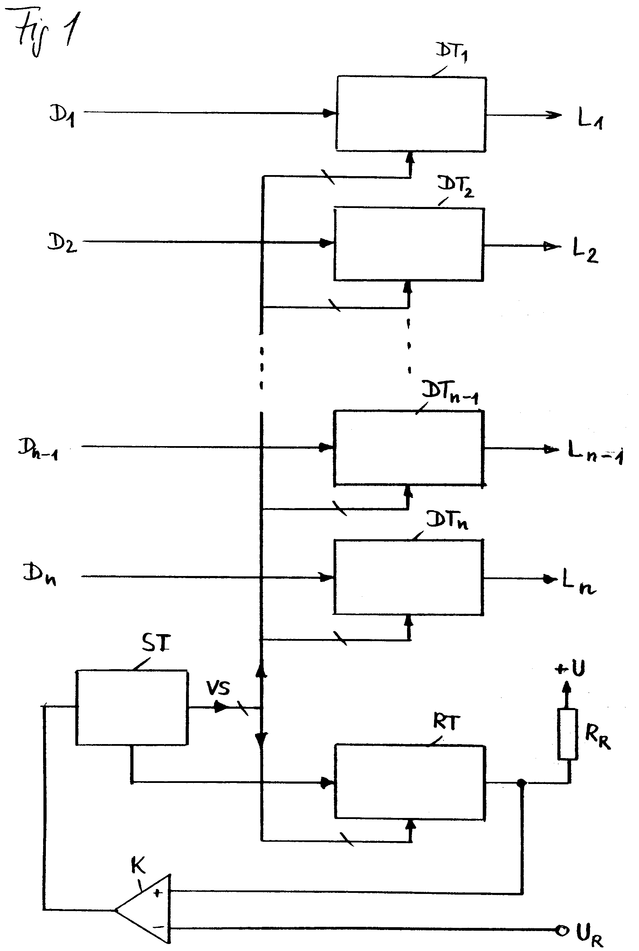

In Fig. 1 sind eine Reihe von Datentreibern $DT_1$, ..., $DT_n$ dargestellt, die ihnen über Dateneingänge D1, ..., Dn zugeführte Signale auf Übertragungsleitungen L1, ..., Ln ausgeben. Die Datentreiber haben definierte, an die Wellenwiderstände der Übertragungsleitungen angepaßte Ausgangsimpedanzen, die durch nicht dargestellte, externe Ausgangswiderstände gebildet werden. Die erforderlichen Ausgangsströme fließen über einen oder mehrere parallelgeschaltete Strompfade, welche durch je ein von einer Steuerschaltung für jeden Strompfad eines Datentreibers separat ausgegebenes Vorbereitungssignal VS angeschaltet werden.

Die Vorbereitungssignale VS werden von der Steuerschaltung ST in Abhängigkeit vom Ausgangssignal eines Komparators K ausgegeben, der die Ausgangsspannung eines auf einen Referenzwiderstand $R_R$ arbeitenden Referenzdatentreibers RT mit einer vorgegebenen Referenzspannung $U_R$ vergleicht und die Steuerschaltung zur Zuschaltung weiterer Strompfade in den Datentreibern veranlaßt, wenn die am Referenzdatentreiber abgegriffene Ausgangsspannung unter die Referenzspannung absinkt. Diese Zuschaltung erfolgt durch Ausgabe anderer oder weiterer Vorbereitungssignale, welche sich auf alle Datentreiber einschließlich des Referenzdatentreibers auswirken.

Innerhalb der Datentreiber werden die Vorbereitungssignale mit den über die jeweiligen Dateneingänge einlaufenden Datensignalen konjunktiv verknüpft, so daß über die externen Ausgangswiderstände die gewünschten Nennströme fließen und die Daten damit mit den gewünschten Amplituden auf die Signalleitungen ausgegeben werden.

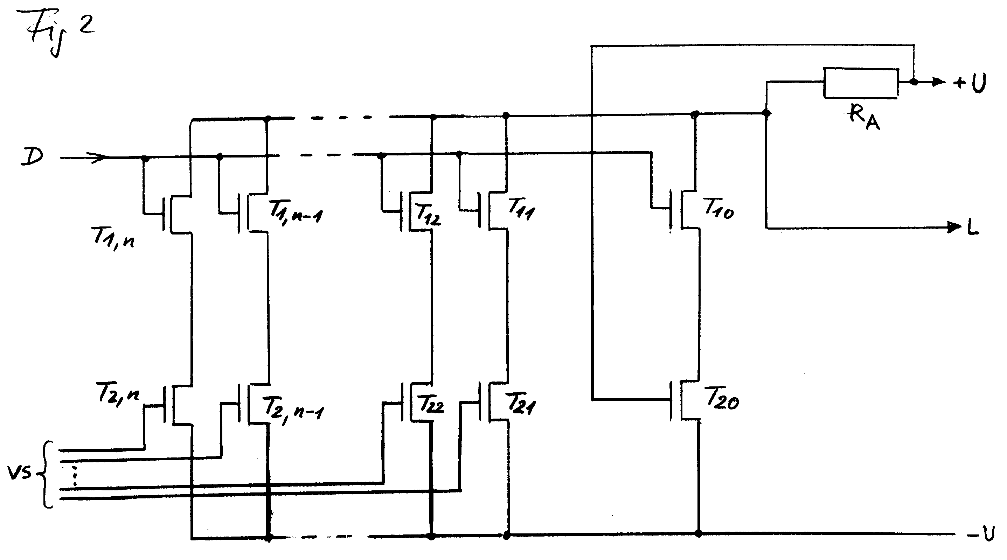

Der Aufbau eines Datentreibers ist in Fig. 2 wiedergegeben. Mehrere, aus jeweils zwei in Reihe geschalteten MOS-Feldeffekttransistoren (MOSFETS) $T_{10}$, $T_{20}$, ..., $T_{1n}$, $T_{2n}$ aufgebaute Strompfade sind einander parallelgeschaltet und bilden in ihrer Gesamtheit einen Teilwiderstand eines Spannungsteilers. Der andere Teilwiderstand dieses Spannungsteilers ist ein gegen positives Potential $+U$ geschalteter externer Arbeitswiderstand $R_A$. An den Verbindungspunkt der beiden Teilwiderstände ist eine Signalleitung L angeschlossen.

Von den jeweils in Reihe geschalteten MOS-Feldeffekttransistoren dienen die in der Figur oben dargestellten, die MOSFETS $T_{10}$, ..., $T_{1,n}$, der Durchschaltung eines über einen Dateneingang D zugeführten digitalen Datenstroms. Die in der Figur unten dargestellten MOSFETS $T_{20}$, ..., $T_{2,n}$ dienen der Einschaltung der einzelnen Strompfade in Abhängigkeit von Vorbereitungssignalen, welche, von der Steuerschaltung erzeugt, über Vorbereitungssignalleitungen VS den Gate-Anschlüssen dieser MOSFETS zugeführt werden.

Lediglich einer der MOSFETS, $T_{20}$, dessen Gate mit positivem Potential und dessen Source mit negativem Potential $-U$ verbunden ist, ist ständig durchgeschaltet.

Alle MOSFETS bilden auch Lastwiderstände. Diese sind so dimensioniert, daß die einzelnen Strompfade vorgegebene Teilströme führen. In dem in Fig. 2 dargestellten Datentreiber ist der rechts dargestellte Strompfad so ausgelegt, daß der über die MOSFETS $T_{10}$ und $T_{20}$ fließende Strom geringfügig unter dem über den Arbeitswiderstand fließenden Nennstrom bleibt. Die anderen Strompfade sind so ausgelegt, daß sie in ihrer Gesamtheit, d.h. parallelgeschaltet, einen zusätzlichen Strom liefern, der den über den Arbeitswiderstand fließenden Strom auf einen Wert, wenig über den Nennstrom hinaus, erhöht. Die Lastwiderstände der einzelnen Strompfade sind dabei entweder gleichgroß oder aber so abgestuft, daß sich ihre Leitwerte wie Potenzen einer positiven Zahl, z.B. der Zahl 2 verhalten.

Anstelle von MOSFETS können in einer Datentreiberschaltung, wie sie in Fig. 2 wiedergegeben ist, auch Bipolartransistoren verwendet werden. Um die gewünschten Widerstandswerte für die einzelnen Strompfade zu erhalten, werden dann zweckmäßig Widerstände eingefügt. Desgleichen ist die Verwendung von p-Kanal-MOSFETS anstelle der in Fig. 2 dargestellten n-Kanal-MOSFETS möglich wie auch der Aufbau der Datentreiberschaltungen mit umgekehrter Ausgangspolarität.

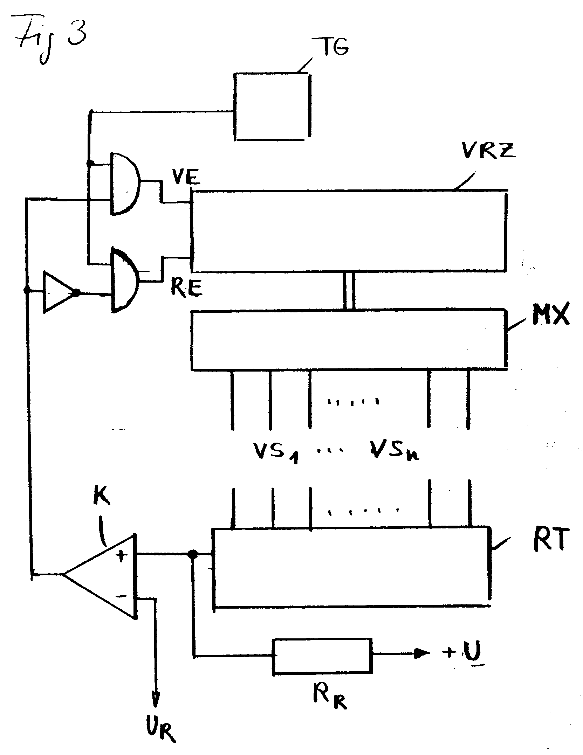

In Fig. 3 ist das Prinzip einer Steuerschaltung wiedergegeben, die geeignet ist, Vorbereitungssignale für eine größere Anzahl von z.B. in einem IC vereinigten Datentreibern abzugeben.

Ein Vorwärts-Rückwärts-Zähler VRZ zählt Impulse eines Taktgebers TG, die über je ein Und-Glied entweder auf einen Vorwärtszähleingang VE oder auf einen Rückwärtszähleingang RE gelangen. Der Parallelausgang des Vorwärts-Rückwärts-Zählers ist auf einen Multiplexer MX geführt, dessen Ausgängen die Vorbereitungssignale VS1, ..., VSn entnommen werden. Die Vorbereitungssignale werden auch einem Referenz-Datentreiber RT zugeführt, der in seinem Aufbau den Nutz-Datentreibern entspricht, jedoch anstatt auf eine Signalleitung, auf einen Referenzwiderstand $R_R$ arbeitet. Werden bei diesem Referenztreiber alle die sonst von der Datenleitung angesteuerten Transistoren ständig durchgeschaltet, so fließt über den Referenzwiderstand ein Strom, der von Anzahl und Wertigkeit der Vorbereitungssignale abhängig ist und der den Nennstrom darstellt.

Zur Konstantregelung dieses Nennstromes wird die am Referenzwiderstand $R_R$ gegen positives Potential $+U$ abfallende Spannung abgegriffen und in einem Komparator K mit einer vorgegebenen Referenzspannung $U_R$ verglichen. Der Komparatorausgang ist einmal direkt, einmal über einen Inverter mit Eingängen der Und-Glieder verbunden, die den beiden Zählereingängen vorgeschaltet sind.

Übersteigt der am Referenzwiderstand auftretende Spannungsabfall die Referenzspannung, wird durch den Komparator der Rückwärtszähleingang des Zählers VRZ geöffnet. Der Zähler zählt damit rückwärts, was zur Abschaltung von Vorbereitungssignalen und damit zur Unterbrechung von Strompfaden in den Datentreibern führt. Da auch der Referenzdatentreiber von den Vorbereitungssignalen beaufschlagt wird, sinkt auch der Strom durch den Referenzwiderstand $R_R$. Der durch diesen Strom verursachte Spannungabfall sinkt dadurch unter die Referenzspannung $U_R$ ab, was ein Umsteuern des Rückwärtszähleingangs und die Öffnung des Vorwärtszähleingangs der Zählers VRZ zur Folge hat. Der Zähler aktiviert damit wieder zusätzliche Vorbereitungssignalleitungen

Wird anstelle eines gewöhnlichen Komparators ein Fensterkomparator eingesetzt, so kann leicht ein Zustand realisiert werden, in dem der Zähler weder vorwärts noch rückwärts zählt. Es besteht dann auch die Möglichkeit, die Regelung der Treiber-Ausgangsströme nur von Zeit zu Zeit vorzunehmen. Der Referenztreiber braucht dann nicht ständig in Betriebs zu sein.

**Patentansprüche**

1. Schaltungsanordnung zur Bereitstellung eines vorgegebenen Ausgangsstromes aus einem ein Datensignal auf eine Leitung ausgebenden Datentreiber mit einem Komparator zur Erfassung einer Ausgangsspannung und Bewertung dieser Ausgangsspannung gegenüber einer Referenzspannung und mit einer Steuerschaltung, welche abhängig vom Ausgangssignal des Komparators ein Stellglied ansteuert, das den Ausgangsstrom verändert,
**dadurch gekennzeichnet,** daß das Stellglied mehrere parallele ($T_{10}$, $T_{20}$, ..., $T_{1n}$, $T_{2n}$) Strompfade besitzt, welche je einen ohm'schen Lastwiderstand aufweisen und unabhängig voneinander einschaltbar sind, wobei zur Einschaltung eines Strompfades ein dem Datentreiber zugeführtes Datensignal und ein Vorbereitungssignal der Steuerschaltung (ST) im Sinne einer Und-Verknüpfung zusammenwirken und daß ein Vorbereitungssignal nur an Schaltelemente solcher Strompfade ausgegeben wird, deren Durchgangsströme in ihrer Summe dem vorgegebenen Ausgangsstrom entsprechen.

2. Schaltungsanordnung nach Anspruch 1, dadurch gekennzeichnet, daß ein erster der parallelen Strompfade einen ohm'schen Lastwiderstand aufweist, der so bemessen ist, daß der über ihn fließende Strom um einen vorgebenen Betrag niedriger als der vorgegebene Ausgangsstrom ist und daß die ohm'schen Lastwiderstände der anderen parallelen Strompfade untereinander gleich und so hoch bemessen sind, daß die über sie fließenden Ströme zusammen mit dem über den ersten parallelen Strompfad fließenden Strom einen Gesamtstrom ergeben, der um einen vorgegebenen Betrag höher als der vorgegebene Ausgangsstrom ist.

3. Schaltungsanordnung nach Anspruch 1, dadurch gekennzeichnet, daß die ohm'schen Lastwiderstände der parallelen Strompfade so bemessen sind, daß die über sie fließenden Ströme einen Gesamtstrom ergeben, der um einen vorgegebenen Betrag höher als der vorgegebene Ausgangsstrom ist und daß sich die Leitwerte der ohm'schen Lastwiderstände zueinander wie Potenzen einer positiven Zahl, insbesondere der Zahl 2, verhalten.

4. Schaltungsanordnung nach Anspruch 1, 2 oder 3, dadurch gekennzeichnet, daß die Steuerschaltung (ST) über weitere Stellglieder die Ausgangsströme weiterer gleichartiger Datentreiber ($DT_1$, ..., $DT_n$) verändert.

5. Schaltungsanordnung nach einem der vorstehenden Ansprüche, dadurch gekennzeichnet, daß ein auf einen Referenzwiderstand arbeitender, dem Datentreiber in seinem Aufbau entsprechender Referenzdatentreiber vorgesehen ist und daß als Ausgangsspannung zur Bewertung gegenüber einer Referenzspannung die Ausgangsspannung dieses Referenzdatentreibers verwendet wird.

6. Schaltungsanordnung nach Anspruch 5, dadurch gekennzeichnet, daß der Referenzdatentreiber (RT) nur von Zeit zu Zeit - für eine vorgegebene Zeit - angeschaltet wird, und daß die Steuerschaltung (ST) ein während dieser Anschaltzeit ermitteltes Stellglied-Steuersignal speichert und bis zur nächsten Anschaltzeit bereithält.

7. Schaltungsanordnung nach einem der vorstehenden Ansprüche, dadurch gekennzeichnet, daß die Steuerschaltung einen Zähler (VRZ) enthält, der abhängig vom Komparator-Ausgangssignal aufwärts oder abwärts zählt und daß bei Erreichen vorgegebener Zählerstände Vorbereitungssignale an Schaltelemente ($T_{1,0}$, ..., $T_{2,n}$) vorgegebener Strompfade ausgegeben werden.

8. Schaltungsanordnung nach Anspruch 7, dadurch gekennzeichnet, daß der Zähler einen Binärausgang besitzt, daß die auf den Ausgangs-Bitleitungen dieses Binärausgangs anstehenden Signale als Vorbereitungssignale für Schaltelemente ($T_{21}$, ..., $T_{2n}$) vorgegebener paralleler Strompfade verwendet werden, und daß die Zuordnung der Strompfade zu den einzelnen, die Vorbereitungssignale führenden Ausgangs-Bitleitungen so gewählt ist, daß der Leitwert eines jeweiligen Strompfades der Wertigkeit der das Vorbereitungssignal für den Strompfad führenden Bitleitung proportional ist.

Fig 1

Fig 2

$D$

$T_{1,n}$   $T_{1,n-1}$   $T_{12}$   $T_{11}$   $T_{10}$

$R_A$

$+U$

$L$

$T_{2,n}$   $T_{2,n-1}$   $T_{22}$   $T_{21}$   $T_{20}$

VS

$-U$

EP 0 482 392 A2

Fig 3